**Europäisches Patentamt**

**European Patent Office**

**Office européen des brevets**

(19)

(11) Veröffentlichungsnummer : **0 500 706 B1**

(12) **EUROPÄISCHE PATENTSCHRIFT**

(45) Veröffentlichungstag der Patentschrift :
18.05.94 Patentblatt 94/20

(51) Int. Cl.⁵ : **G01L 3/00**

(21) Anmeldenummer : **90917150.6**

(22) Anmeldetag : **16.11.90**

(86) Internationale Anmeldenummer :
**PCT/AT90/00110**

(87) Internationale Veröffentlichungsnummer :
**WO 91/07644 30.05.91 Gazette 91/12**

(54) **VERFAHREN ZUR ERMITTLUNG DES MECHANISCHEN DREHMOMENTES.**

(30) Priorität : **16.11.89 AT 2630/89**

(43) Veröffentlichungstag der Anmeldung :
**02.09.92 Patentblatt 92/36**

(45) Bekanntmachung des Hinweises auf die
Patenterteilung :
**18.05.94 Patentblatt 94/20**

(84) Benannte Vertragsstaaten :
**AT DE FR GB IT SE**

(56) Entgegenhaltungen :
**DE-B- 2 144 438**
**US-A- 4 333 118**
**US-A- 4 435 987**
**US-A- 4 616 179**
**Patent Abstracts of Japan, vol. 10, no. 165,**
**P-467, abstract of JP-61-17923 publ. 25.01.86**

(73) Patentinhaber : **ELIN ENERGIEANWENDUNG**
**GESELLSCHAFT M.B.H.**
**Penzinger Strasse 76**
**A-1141 Wien (AT)**

(72) Erfinder : **BERGER, Hubert**
**Johann-Strauss-Gasse 4/3/27**
**A-1040 Wien (AT)**

(74) Vertreter : **Krause, Peter**
**c/o Elin Energieanwendung GMBH, Penzinger**
**Strasse 76**
**A-1141 Wien (AT)**

## Beschreibung

Die Erfindung betrifft ein Verfahren zur Ermittlung des mechanischen Drehmomentes an der Welle einer über einen Strom- oder Spannungszwischenkreisumrichter gespeisten Asynchronmaschine, die mit einer Kraft- bzw. Arbeitsmaschine bzw. -einrichtung oder einem Prüfling, vorzugsweise einer Verbrennungskraftmaschine, gekuppelt ist.

Die Erfindung betrifft auch eine Einrichtung zur Durchführung dieses Verfahrens.

Das an der Welle einer elektrischen Maschine abgegebene mechanische Drehmoment erhält man allgemein aus dem inneren Luftspaltmoment $M_i$ durch Abzug des mechanischen Reibungsmomentes $M_{Rb}$ sowie des Beschleunigungsmomentes $J_p \cdot \dfrac{d\omega_m}{dt}$ :

$$M_m = M_i - M_{Rb} - J_p \cdot \frac{d\omega_m}{dt}$$

$J_p$.....Massenträgheitsmoment

$\omega_m$.....mechanische Winkelgeschwindigkeit

Das auf den Rotor übertragene elektromagnetische Moment $M_i$ kann allgemein aus der zugeführten elektrischen Leistung $P_{1,el}$ durch Abzug der gesamten elektrischen Verluste $V_{el}$ und anschließender Division durch die mechanische Winkelgeschwindigkeit $\omega_m$

$(\omega_m = 2\,\pi n)$

$$M_i = \frac{P_{1,el} - \Sigma V_{el}}{\omega_m}$$

berechnet werden.

Wie aus der Theorie der sinusgespeisten Maschine bekannt ist, kann das Drehmoment auch aus der Drehfeldleistung $P_D$ und der auf die Polpaarzahl p bezogene Statorgrundschwingungskreisfrequenz $\omega_s$ gemäß

$$M_i = \frac{P_D}{\omega_s} \cdot p$$

berechnet werden.

In der EP-OS 0 019 137 ist ein Drehmoment-Istwertrechner für Prüfstände beschrieben, der mit einem Mikroprozessor aufgebaut ist. Das mechanische Drehmoment wird aus den elektrischen Daten einer mit dem Prüfling gekoppelten Gleichstrommaschine ermittelt. Das Verlustmoment ist in Leerlaufverlustmoment und stromabhängiges Zusatzmoment aufgeteilt, deren Werte als Funktion der Drehzahl gespeichert sind.

Die stromabhängigen Zusatzmomente, die sich nicht mehr ändern, werden von vornherein im Festwertspeicher abgelegt. Das Leerlaufverlustmoment, dessen Werte sich ändern können, wird in einem Leerlaufversuch am Prüfstand ermittelt.

Das hier zugrunde gelegte Berechnungsprinzip läßt sich jedoch nicht auf die immer häufiger eingesetzten Drehstrommotoren übertragen.

In der US-A-4 616 179 wird ein Verfahren gemäß dem Oberbegriff des Patentanspruchs 1 beschrieben.

Die Aufgabe der Erfindung besteht nun darin, für umrichtergespeiste Asynchronmaschinen ein Verfahren und eine Einrichtung zur Durchführung des Verfahrens zu schaffen, bei welchem nur unter Heranziehung von elektrisch meßbaren Größen beim Umrichter und in der Einrichtung abgespeicherter Größen das mechanische Drehmoment an der Welle der Asynchronmaschine ermittelt wird.

Diese wird durch die Erfindung gelöst, welche dadurch gekennzeichnet ist, daß beim Verfahren der eingangs genannten Art im Zwischenkreis des Umrichters Strom- und Spannungswerte gemessen werden, daß aus diesen Werten die über einen wählbaren Zeitbereich gemittelte Wirkleistung im Zwischenkreis berechnet wird, daß aus diesem Wert $P_{ZK}$ durch Subtraktion aller Verlustleistungsanteile des Wechselrichters, sowie durch Subtraktion der elektrischen und mechanischen Verlustleistungsanteile der Maschine, ausgenommen der Rotorkupferverluste der Grundschwingung eine modifizierte Drehfeldleistung berechnet wird, daß die modifizierte Drehfeldleistung durch die auf die Polpaarzahl bezogene Statorgrundschwingungskreisfrequenz der Asynchronmaschine, welche der Steuer- und Regelelektronik des Umrichters entnehmbar ist, dividiert wird, und daß dieser Wert dem mechanischen Drehmoment vermindert um das aus dem Trägheitsmoment und der Drehzahländerung berechnete Beschleunigungsmoment gleichgesetzt wird. Der wesentlichste Vorteil der Erfindung liegt darin, daß die aufgrund ihrer Temperaturabhängigkeit schwer zu bestimmenden Rotorkupferverluste der Grundschwingung bei der Ermittlung des Wellendrehmomentes nicht berücksichtigt werden müssen. Durch die Messung der Strom- und Spannungswerte im Zwischenkreis wird aufgrund der dort auftretenden Signalformen bei der Berechnung der Zwischenkreis-Wirkleistung eine hohe Genauigkeit erreicht. Mit der Einrichtung wird das mechanische Drehmoment unter Betrachtung der Leistungsbilanz ermittelt, wodurch höchste Genauigkeit bei vertretbarem meßtechnischen Aufwand erzielt wird.

Von Vorteil ist, daß die Verlustleistungsanteile des Wechselrichters (2), insbesondere die Durchlaß-, Schalt- und Kommutierungsverluste aus dem im Zwischenkreis gemessenen Strom, der der Steuer- und Regelelektronik des Umrichters entnehmbaren Statorgrundschwingungsfrequenz und den Wechselrichterkennwerten, insbesondere den statischen und dynamischen Kennwerten von Thyristoren und Dioden und deren Beschaltungselementen, berechnet werden. Alle Wechselrichterverlustleistungsanteile können dadurch mit geringem Meßaufwand ermittelt werden.

Ein weiterer Vorteil der Erfindung ist, daß die von der Wirkleistung im Zwischenkreis subtrahierten Verlustleistungsanteile der Maschine, die sich aus den Statorkupfer-, den Eisen-, den Zusatz-, den Reibungs- und den Rotoroberschwingungsverlusten zusammensetzen, aus dem Zwischenkreisstrom und den aus Maschinenparametern ermittelten Ersatzwiderständen berechnet werden, wobei die Ersatzwiderstände von der Statorgrundschwingungsfrequenz und der, z.B. mit einem Temperaturmeßwiderstand gemessenen, Statortemperatur abhängig sind. Wie erkennbar, werden auch die benötigten Maschinenverlustleistungsanteile mit relativ geringem Meßaufwand und der erforderlichen Genauigkeit berechnet.

Nach einer Weiterbildung wird zum Kalibrieren die Asynchronmaschine mit einem drehmomentregelbaren Antrieb gekuppelt, der ein mechanisch gemessenes Referenzmoment zur Verfügung stellt, der Frequenzbereich der Asynchronmaschine wird bei drei unterschiedlichen Lastmomentwerten, vorzugsweise bei Leerlauf, 2/3-Last und Vollast, durchlaufen, und aus der Differenz zwischen dem zugeführten Referenzmoment und dem berechneten Drehmoment wird die zugehörige Differenz der korrespondierenden modifizierten Drehfeldleistungen berechnet und hieraus eine frequenz- und stromabhängige Korrekturfunktion bestimmt. Durch obigen Kalibriervorgang werden für den gesamten Betriebsbereich Meßungenauigkeiten, sowie Ungenauigkeiten bei der Berechnung der Verluste korrigiert.

Bei der Einrichtung zur Durchführung des Verfahrens ist ein Mikrorechner mit einer Ein-/Ausgabeeinheit, die die Strom- und Spannungswerte im Zwischenkreis des Umrichters erhält, verbunden, der Mikrorechner berechnet mit einem in seiner Speichereinheit abgelegten Programm die Wirkleistung im Zwischenkreis und legt diese in einem freien Speicherplatz in der Speichereinheit ab und ein weiteres im Mikrorechner abgelegtes Programm berechnet die modifizierte Drehfeldleistung und dividiert diese durch die, der Steuer- und Regelelektronik des Umrichters entnommenen und der Ein-/Ausgabeeinheit zugeführten, Statorgrundschwingungskreisfrequenz.

Von Vorteil ist bei der Einrichtung, daß der Mikrorechner mit einem Programm die Verlustleistungsanteile des Wechselrichters, mit dem im Zwischenkreis gemessenen Strom, der Statorgrundschwingungsfrequenz und der in freien Speicherplätzen in der Speichereinheit des Mikrorechners abgelegten Wechselrichterkennwerten, berechnet.

Ein weiterer Vorteil der Einrichtung ist, daß der Mikrorechner mit einem Programm die Verlustleistungsanteile aus den in der Speichereinheit in freien Speicherplätzen abgelegten frequenz- und temperaturabhängigen Ersatzwiderständen, welche aus den in Festwertspeichern abgespeicherten Maschinenparametern mit einem weiteren Programm im Mikrorechner errechnet sind, dem Zwischenkreisstrom, der Statorgrundschwingungsfrequenz und der Statortemperatur berechnet.

Nachfolgend wird die Erfindung an Hand der Zeichnungen noch näher erläutert.

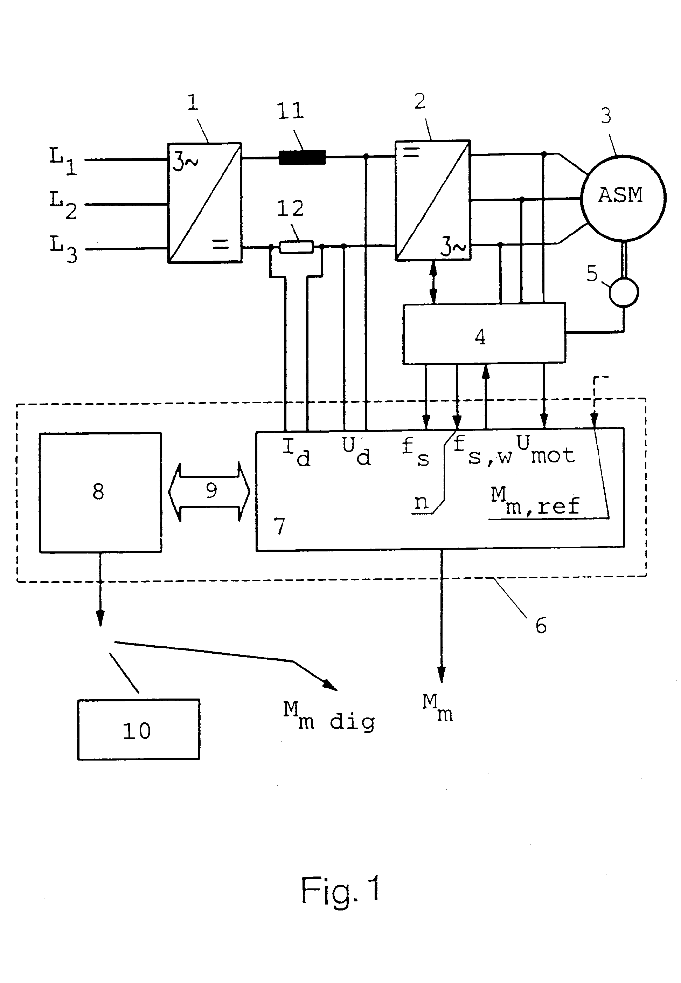

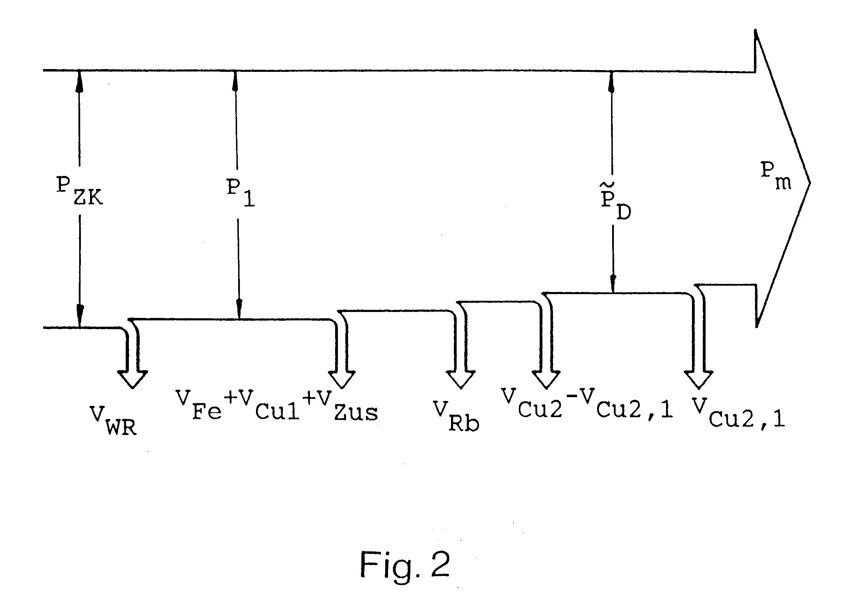

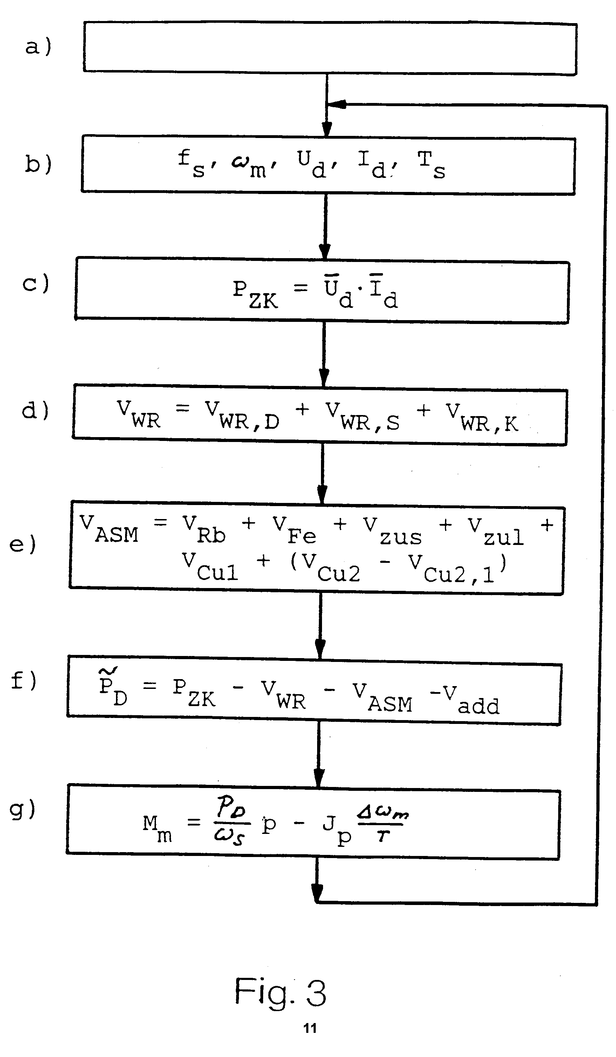

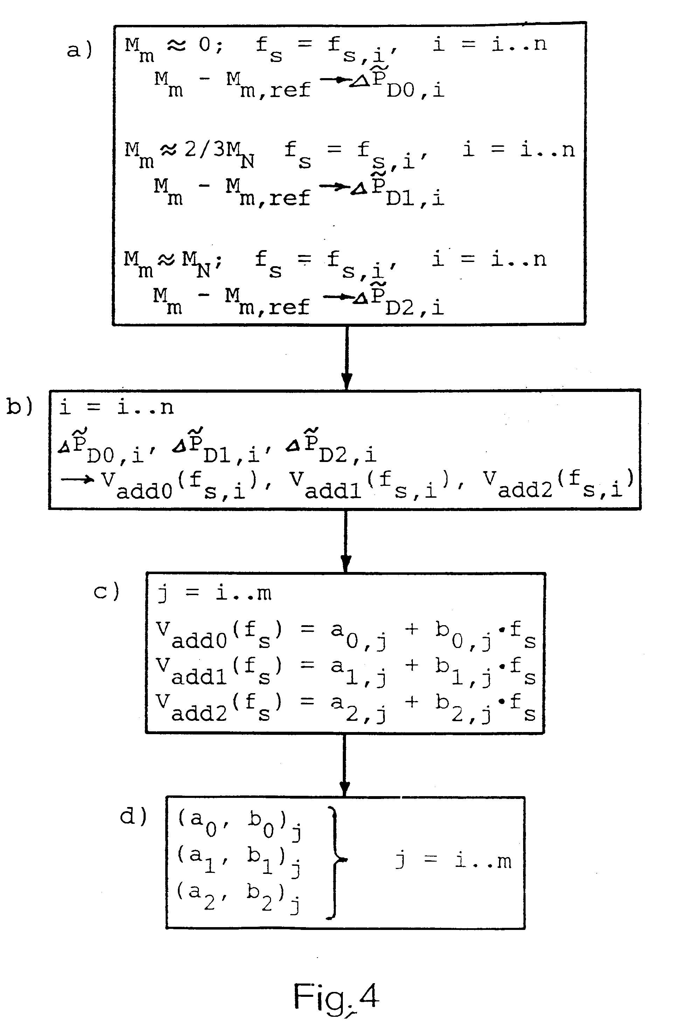

Die Fig. 1 zeigt schematisch die, hier mit einem Stromzwischenkreisumrichter verbundene, Einrichtung, Fig. 2 stellt den Leistungsfluß vom Zwischenkreis bis zur Welle der Asynchronmaschine dar, Fig. 3 zeigt das Flußdiagramm zur Berechnung des mechanischen Drehmomentes und aus dem Flußdiagramm in Fig. 4 ist die Ermittlung der frequenz- und stromabhängigen Korrekturfunktion bei der Kalibrierung zu erkennen.

Bei Fig. 1 stellen die drei Phasen $L_1$, $L_2$, $L_3$ das Drehstromnetz dar, an welches ein Netzstromrichter 1 angeschlossen ist. Dieser Stromrichter 1 ist über den Stromzwischenkreis mit der Glättungsdrossel 11 und dem Strommeßwiderstand 12 mit dem Wechselrichter bzw. Maschinenstromrichter 2 verbunden. An diesen ist die Asynchronmaschine 3 angeschlossen. Weiters ist eine Steuer- und Regelelektronik 4 für den Maschinenstromrichter 2 vorgesehen. Dieser wird die Drehzahl der Maschine 3, welche z. B. mit einer Zahnscheibe 5 und zwei Impulsgebern erfaßt wird, und die Maschinenspannung zugeführt.

Die erfindungsgemäße Einrichtung 6 besteht aus einer Ein-/Ausgabeeinheit 7 und dem Mikrorechner 8 mit einer Speichereinheit, welche über Busleitungen 9 verbunden sind. Der Ein-/Ausgabeeinheit 7 wird der Zwischenkreisstrom $I_d$ und die Zwischenkreisspannung $U_d$, sowie von der Steuer- und Regelelekronik 4 der Istwert der Statorfrequenz $f_s$, die Maschinenspannung $U_{Mot}$ und die Maschinendrehzahl n zugeführt. Den Sollwert der Statorfrequenz $f_{s,w}$ erhält die Steuer- und Regelelektronik 4 von der Ein-/Ausgabeeinheit 7. Beim Kalibriervorgang gelangt an diese Ein-/Ausgabeeinheit 7 auch ein Referenzmoment $M_{m,ref}$. Die erfindungsgemäße Einrichtung 6 kann das ermittelte Drehmoment $M_m$ digital oder analog ausgeben. Weiters kann an die Einrichtung 6 ein Terminal 10 zur Programmierung des Mikrorechners 8 und zur Ein- und Ausgabe von Daten angeschlossen werden.

Bei dem Leistungsfluß in Fig. 2 ist $P_{ZK}$ die Zwischenkreisleistung, $P_1$ die der Asynchronmaschine 3 zuge-

3

führte Leistung, $\widetilde{P}_D$ die modifizierte Drehfeldleistung und $P_m$ die an der Maschinenwelle abgegebene Leistung.

Durch bloße Vorausberechnung der Verlustanteile aus Maschinen- und Wechselrichterkenngrößen kann für manche Anwendungsfälle keine für die Drehmomentberechnung ausreichende Genauigkeit erzielt werden. Aus diesem Grund ist eine Kalibrierung zweckmäßig, bei der die bei Vergleich mit einem Referenzmoment festgestellte Abweichung korrigiert wird.

Die Korrektur erfolgt mit Hilfe einer Funktion, in der der Zwischenkreisstrom $I_d$ und die Statorfrequenz $f_s$ als Variable auftreten.

$$V_{add}(f_s, I_d) = V_{add0}(f_s) + V_{add1}(f_s)\left[\frac{I_d}{I_{dN}}\right] + V_{add2}(f_s)\left[\frac{I_d}{I_{dN}}\right]^2$$

Um die Koeffizienten dieser zusätzlichen Verlustfunktion zu bestimmen, wird das berechnete Drehmoment mit einem Referenzmoment verglichen. Das Referenzmoment kann durch Einbau einer Drehmomentmeßwelle oder durch Kuppeln mit einem Pendelmaschinenantrieb bereitgestellt werden. Pendelmaschinen haben den Vorteil, daß die physikalische Größe Drehmoment in direkter Weise auf die Größen Länge und Kraft (Hebelarm und Gewicht) rückgeführt werden kann.

Es wird eine Schar relativ dicht beieinander liegender Frequenzpunkte ($f_{s,i}$, i= 1,2,...,n) betrachtet, für die bei jeweils drei unterschiedlichen Lastzuständen (unterschiedliche Werte von $I_d$) durch Vergleich mit dem Referenzmoment $M_{m,ref}$ der Wert für die zusätzliche Verlustleistung bestimmt wird. Für jeden dieser diskreten Frequenzwerte werden daraus die Koeffizienten ($V_{add0,i}$, $V_{add1,i}$, $V_{add2,i}$, i= 1,2,...,n) der zusätzlichen Verlustfunktion berechnet.

Um aus dieser Koeffizientenschar eine geschlossene Darstellung für die Verlustfunktion zu erhalten, werden die Funktionen $V_{add0}(f_s)$, $V_{add1}(f_s)$, $V_{add2}(f_s)$ als abschnittsweise linear in $f_s$ angesetzt. Die Geradenstücke der einzelnen Abschnitte werden dann mittels Regression aus den aufgenommenen Daten bestimmt.

Dieser Ausgleich der Koeffizienten ist gleichbedeutend mit einem Ausgleich der bei konstant gehaltenem Strom aufgenommenen Differenzmomente. Dadurch, daß zuerst die Koeffizienten $V_{add0,i}$, $V_{add1,i}$, $V_{add2,i}$ für die einzelnen Frequenzen berechnet werden und die Glättung erst über diese Koeffizienten erfolgt, ist bei der Messung die genaue Konstanthaltung des Stromes nicht notwendig.

Die beschriebene Kalibrierung kann auf den generatorischen sowie auf den motorischen Beriebsbereich angewendet werden.

Bei dem Flußdiagramm in Fig. 3 bedeuten:

a) Aufbereitung der Maschinen- und Umrichterkennwerte Teilweise Abspeicherung in Feldern, um beim on-line Berechnungszyklus Rechenzeit zu sparen

b) Erfassung der angeführten Meßgrößen

c) Berechnung der Wirkleistung im Zwischenkreis (motorseitig)

d) Berechnung der Wechselrichterverluste

e) Berechnung der Maschinenverluste

f) Berechnung der modifizierten Drehfeldleistung mit Berücksichtigung der durch die Korrekturfunktion beschriebenen zusätzlichen Verluste

g) Berechnung des Wellendrehmomentes unter Berücksichtigung des rotoreigenen Beschleunigungsmomentes

Bei dem Flußdiagramm in Fig. 4 bedeuten:

a) Aufnahme der Differenz zwischen berechnetem und gemessenem Wellendrehmoment Abspeicherung der Differenz zwischen den Werten der korrespondierenden modifizierten Drehfeldleistungen

b) Bestimmung der Koeffizienten der Korrekturfunktion als diskrete Werte für die einzelnen Frequenzpunkte $f_{s,i}$ (Stützstellen)

c) Mittels linearer Regression aus den Werten der Stützstellen werden die Koeffizienten $V_{add0}(f_s)$, $V_{add1}(f_s)$, $V_{add2}(f_s)$ als abschnittsweise lineare Funktion in $f_s$ dargestellt

d) Abspeicherung dieser Kennwerte in nichtflüchtigen Speichern

Abschließend erfolgt noch eine Auflistung der in den Formeln verwendeten Zeichen:

a, b       Kennwerte zur Darstellung der Korrekturfunktion $V_{add}(f_s,I_d)$;

1. Index bezieht sich auf Zuordnung zu $V_{add}^0$, $V_{add}^1$ bzw. $V_{add}^2$;

Index $_j$ kennzeichnet den jeweiligen Frequenzabschnitt

$f_s$    Statorfrequenz; $f_{s,1}$ = diskrete Statorfrequenzen (Stützstellen für die Ermittlung der Korrekturfunktion)

$\bar{I}_d$    Gleichanteil des Zwischenkreisstromes; $I_{dN}$ = Zwischenkreisnennstrom

$J_p$    polares Trägheitsmoment der rotierenden Massen

$M$    Drehmoment; $M_i$ = inneres Drehmoment; $M_m$ = berechnetes Wellendrehmoment; $M_{m,ref}$ mechanisch gemessenes Referenzmoment (Kalibrierung) $M_N$ Nennmoment der Maschine

$p$    Polpaarzahl

$P_{zk}$    Wirkleistung im Zwischenkreis, motorseitig.

$\tilde{P}_D$    modifizierte Drehfeldleistung = Zugeführte Leistung minus gesamter elektr. und mechan. Verluste abzüglich der Rotorgrundschwingungsverluste

$\Delta\tilde{P}_D$    aus der Vergleichsmessung ermittelte Abweichungen der berechneten modifizierten Drehfeldleistungen, 1. Index bezieht sich auf die drei Lastwerte Leerlauf($_0$), 2/3-Last($_1$) und Vollast($_2$)

$T$    Zykluszeit (der Momentberechnung)

$T_s$    Temperatur der Statorwicklung

$\bar{U}_d$    Gleichanteil der Zwischenkreisspannung, motorseitig;

$V_{add}$    Zusätzliche Verlustleistung (Korrekturfunktion); $V_{add}^0$, $V_{add}^1$, $V_{add}^2$ statorfrequenzabhängige Koeffizienten der Korrekturfunktion

$V_{ASM}$    gesamte mechan. und elektr. Verluste der Maschine abzüglich $V_{Cu2,1}$

$V_{Cu}^1$    gesamte Statorkupferverluste

$V_{Cu}^2$    gesamte Rotorkupferverluste

$V_{Cu}^{1,2}$    Rotorkupferverluste der Grundharmonischen

$V_{Fe}$    Eisenverluste des Hauptflußes

$V_{Rb}$    Reibungs- und Lüfterverluste

$V_{WR}$    Wechselrichterverluste gesamt; $V_{WR\text{-}D}$ Durchlaßverluste, $V_{WR,S}$ Schaltverluste, $V_{WR\text{-}K}$ Kommutierungsverluste

$V_{Zu1}$    Kupferverluste in den Maschinenzuleitungen

$V_{zus}$    Zusatzverluste (streuflußbedingte Oberflächen- und Pulsationsverl.)

$\omega$    Kreisfrequenz; $\omega_s$ Statorgrundschwingungskreisfrequenz

$\omega_m$ mechanische Kreisfrequenz ( od. Winkelgeschwindigkeit)

**Patentansprüche**

1. Verfahren zur Ermittlung des mechanischen Drehmo mentes an der Welle einer über einen Strom- oder Spannungszwischenkreisumrichter (1,2) gespeisten Asynchronmaschine (3), die mit einer Kraft- bzw. Arbeitsmaschine bzw. -einrichtung oder einem Prüfling, vorzugsweise einer Verbrennungskraftmaschine, gekuppelt ist, **dadurch gekennzeichnet**, daß im Zwischenkreis des Umrichters (1, 2) Strom- ($I_d$) und Spannungswerte ($U_d$) gemessen werden, daß aus diesen Werten die über einen wählbaren Zeitbereich gemittelte Wirkleistung ($P_{ZK}$) im Zwischenkreis berechnet wird, daß aus diesem Wert der Wirkleistung ($P_{ZK}$) durch Subtraktion aller Verlustleistungsanteile ($V_{WR}$) des Wechselrichters (2), sowie durch Subtraktion der elektrischen und mechanischen Verlustleistungsanteile ($V_{ASM}$) der Asynchronmaschine (3), ausgenommen der Rotorkupferverluste der Grundschwingung ($V_{Cu2,1}$) eine modifizierte Drehfeldleistung ($\tilde{P}_D$) berechnet wird, daß die modifizierte Drehfeldleistung ($\tilde{P}_D$) durch die auf die Polpaarzahl (p) bezogene Statorgrundschwingungskreisfrequenz ($\omega_S$) der Asynchronmaschine (3), welche der Steuer- und Regelelektronik (4) des Umrichters (1, 2) entnehmbar ist, dividiert wird, und daß dieser Wert dem mechanischen Drehmoment ($M_m$) vermindert um das aus dem Trägheitsmoment ($J_p$) und der Drehzahländerung ($\frac{d\omega_m}{dt}$) berechnete Beschleunigungsmoment gleichgesetzt wird.

2. Verfahren nach Anspruch 1, **dadurch gekennzeichnet**, daß die Verlustleistungsanteile ($V_{WR}$) des Wechselrichters (2), insbesondere die Durchlaß- ($V_{WR\text{-}D}$), Schalt- ($V_{WR\text{-}S}$) und Kommutierungsverluste ($V_{WR\text{-}K}$) aus dem im Zwischenkreis gemessenen Strom ($I_d$), der der Steuer- und Regelelektronik (4) des Umrichters (1, 2) entnehmbaren Statorgrundschwingungsfrequenz ($f_s$) und den Wechselrichterkennwerten, insbesondere den statischen und dynamischen Kennwerten von Thyristoren und Dioden und deren Beschaltungselementen, berechnet werden.

3. Verfahren nach Anspruch 1 oder 2, **dadurch gekennzeichnet,** daß die von der Wirkleistung ($P_{ZK}$) im Zwischenkreis subtrahierten Verlustleistungsanteile ($V_{ASM}$) der Maschine (3), die sich aus den Statorkupfer- ($V_{Cu1}$), den Eisen- ($V_{Fe}$), den Zusatz- ($V_{Zus}$), den Reibungs- ($V_{Rb}$) und den Rotoroberschwingungsverlusten zusammensetzen, aus dem Zwischenkreisstrom ($I_d$) und den aus Maschinenparametern ermittelten Ersatzwiderständen berechnet werden, wobei die Ersatzwiderstände von der Statorgrundschwingungsfrequenz ($f_s$) und der, z.B. mit einem Temperaturmeßwiderstand gemessenen, Statortemperatur ($T_s$) abhängig sind.

4. Verfahren nach einem der Ansprüche 1 bis 3, **dadurch gekennzeichnet**, daß zum Kalibrieren die Asynchronmaschine (3) mit einem drehmomentregelbaren Antrieb gekuppelt wird, der ein mechanisch gemessenes Referenzmoment ($M_{m,ref}$) zur Verfügung stellt, daß der Frequenzbereich der Asynchronmaschine (3) bei drei unterschiedlichen Lastmomentwerten, vorzugsweise bei Leerlauf, 2/3-Last und Vollast, durchlaufen wird, und daß aus der Differenz zwischen dem zugeführten Referenzmoment ($M_{m,ref}$) und dem berechneten Drehmoment ($M_m$) die zugehörige Differenz der korrespondierenden modifizierten Drehfeldleistungen ($\Delta \widetilde{\overline{P}}_D$) berechnet wird und hieraus eine frequenz- und stromabhängige Korrekturfunktion ($V_{add}(f_s,I_d)$) bestimmt wird.

5. Einrichtung zur Durchführung des Verfahrens nach einem der Ansprüche 1 bis 4, **dadurch gekennzeichnet,** daß ein Mikrorechner (8) mit einer Ein-/Ausgabeeinheit (7), die im Verwendungsfall die Strom- ($I_d$) und Spannungswerte ($U_d$) im Zwischenkreis des Umrichters (1, 2) erhält, verbunden ist, daß der Mikrorechner (8) mit einem in seiner Speichereinheit abgelegten Programm die Wirkleistung ($P_{ZK}$) im Zwischenkreis berechnen kann und in einem freien Speicherplatz in der Speichereinheit ablegen kann und daß ein weiteres im Mikrorechner (8) abgelegtes Programm die modifizierte Drehfeldleistung ($\widetilde{\overline{P}}_D$) berechnen kann und durch die, der Steuer- und Regelelektronik (4) des Umrichters (1, 2) entnommenen und der Ein-/Ausgabeeinheit (7) zugeführten, Statorgrundschwingungskreisfrequenz ($\omega_s$) dividieren kann.

6. Einrichtung nach Anspruch 5, **dadurch gekennzeichnet**, daß der Mikrorechner (8) mit einem Programm die Verlustleistungsanteile ($V_{WR}$) des Wechselrichters (2), mit dem im Zwischenkreis gemessenen Strom ($I_d$), der Statorgrundschwingungsfrequenz ($f_s$) und der in freien Speicherplätzen in der Speichereinheit des Mikrorechners (8) abgelegten Wechselrichterkennwerten, berechnen kann.

7. Einrichtung nach einem der Ansprüche 5 und 6, **dadurch gekennzeichnet**, daß der Mikrorechner (8) mit einem Programm die Verlustleistungsanteile ($V_{ASM}$) aus den in der Speichereinheit in freien Speicherplätzen abgelegten frequenz- und temperaturabhängigen Ersatzwiderständen, welche aus den in Festwertspeichern abgespeicherten Maschinenparametern mit einem weiteren Programm im Mikrorechner (8) errechnet sind, dem Zwischenkreisstrom ($I_d$), der Statorgrundschwingungsfrequenz ($f_s$) und der Statortemperatur ($T_s$) berechnen kann.

## Claims

1. Process for determining the mechanical torque at the shaft of a current-source or voltage-source converter-fed (1, 2) asynchronous machine (3) that is coupled to a prime mover or driven machine or installation or a test specimen, preferably an internal combustion engine, characterised in that current values ($I_d$) and voltage values ($U_d$) are measured in the link circuit of the converter (1, 2), that the active power ($P_{ZK}$) in the link circuit determined over a selectable time interval is calculated from these values, that a modified rotor power input is calculated from this active power value $P_{ZK}$ by subtracting all power dissipation components ($V_{WR}$) of the inverter (2), and by subtracting the electrical and mechanical power dissipation components $V_{ASM}$ of the asynchronous machine (3), with the exception of the rotor copper losses at the fundamental frequency ($V_{Cu2,1}$), that the modified rotor power input $\overline{P}_D$ is divided by the fundamental angular frequency ($\omega_s$) of the stator of the asynchronous machine (3) referred to the number of pole pairs (p), which can be derived from the control electronics (4) of the converter (1, 2), and that this value equals the mechanical torque ($M_m$), reduced by the accelerating torque calculated from the moment of inertia ($J_p$) and the speed variation ($\frac{d\omega m}{dt}$)

2. Process according to Claim 1, characterised in that the power dissipation components ($V_{WR}$) of the inverter (2), especially the forward power losses ($V_{WR\text{-}D}$), switching losses ($V_{WR\text{-}S}$) and commutation losses

($V_{WR-K}$) are calculated from the current ($I_d$) measured in the link circuit, the stator fundamental frequency ($f_s$) derived from the control electronics (4) of the converter (1, 2), and the inverter characteristic values, especially the static and dynamic characteristics of thyristors and diodes and their circuit elements.

3. Process according to Claim 1 or 2, characterised in that the power dissipation components ($V_{ASM}$) of the machine (3) subtracted from the active power ($P_{ZK}$) in the link circuit, which are made up of the stator, copper ($V_{Cu1}$), iron ($V_{Fe}$), stray ($V_{Zus}$), frictional ($V_{Rb}$) and rotor harmonic losses, are calculated from the link circuit current ($I_d$) and the equivalent resistances determined from machine parameters, the equivalent resistances depending on the stator fundamental frequency ($f_s$) and the stator temperature ($T_s$) being measured with a temperature-measuring resistor.

4. Process according to one of the Claims 1 to 3, characterised in that for calibration, the asynchronous machine (3) is coupled to a variable-torque drive that supplies a mechanically measured reference torque ($M_{m,ref}$), that the frequency range of the asynchronous machine (3) is run at three different load torque values, preferably at no load, 2/3rds load and full load, and the associated difference in the corresponding, modified rotor power inputs ($\Delta\overline{P}_D$) is calculated from the difference between the applied reference torque ($M_{m,ref}$) and the calculated torque ($M_m$), and a frequency-dependent and current-dependent correction function ($V_{add}(f_s,I_d)$) determined therefrom.

5. Device for implementing the process according to one of the one of the Claims 1 to 4, characterised in that a microcomputer (8) is connected to an input/output unit (7) which, in the application, receives the current ($I_d$) and voltage ($U_d$) values in the link circuit of the converter (1, 2), that with a program stored in its memory unit the microcomputer (8) can calculate the active power ($P_{ZK}$) in the link circuit and can store this in a free memory location in the memory unit and that a further program stored in the microcomputer (8) can calculate the modified rotor power input ($\overline{P}_D$) and can divide this by the fundamental angular frequency of the stator ($\omega_s$) derived from the control electronics (4) of the converter (1, 2) and fed to the input/output unit (7).

6. Device according to Claim 5, characterised in that with a program the microcomputer (8) can calculate the power dissipation components ($V_{WR}$) of the inverter (2), with current ($I_d$) measured in the link circuit, the stator's fundamental frequency ($f_s$) and the inverter characteristic values stored in the free memory locations in the memory unit of the microcomputer (8).

7. Device according to one of the Claims 5 and 6, characterised in that with a program, the microcomputer (8) can calculate the power dissipation components ($V_{ASM}$) from the frequency-dependent and temperature-dependent equivalent resistances stored in the free memory locations in the memory unit, which are calculated with a further program in the microcomputer (8) from the machine parameters stored in the read-only memories, and from the link circuit current ($I_d$), the stator fundamental frequency ($f_s$) and the stator temperature ($T_s$).

## Revendications

1. Procédé pour la détermination du couple de rotation mécanique sur l'arbre d'une machine asynchrone (3) alimentée par l'intermédiaire d'un mutateur d'intensité ou de tension intermédiaire (1, 2), qui est couplée avec une machine ou un dispositif à moteur ou de travail ou témoin, de préférence une machine motrice à combustion, caractérisé en ce que des valeurs d'intensité ($I_d$) et de tension ($U_d$) sont mesurées dans le circuit intermédiaire du mutateur (1, 2), en ce que la puissance active ($P_{ZK}$) dont la moyenne est établie sur une plage de temps est calculée à partir de ces valeurs dans le circuit intermédiaire, en ce qu'à partir de ces valeurs de la puissance active ($P_{ZK}$) une puissance de champ rotatif ($\widetilde{P}_D$) modifiée est calculée par soustraction de toutes les parties de perte ($V_{WR}$) du mutateur (2), ainsi que par soustraction des parties de puissance dissipée électriques et mécaniques ($V_{ASM}$) de la machine asynchrone (3), à l'exception des pertes dans le cuivre du rotor de la vibration fondamentale ($V_{Cu2,1}$), en ce que la puissance de champ rotatif ($\widetilde{P}_D$) modifiée est divisée par la fréquence de circuit fondamentale du stator ($W_s$) de la machine asynchrone (3) rapportée au nombre de paires de pôles (p), qui peut être obtenue à partir de l'électronique de commande et de réglage (4) du mutateur (1, 2), et en ce que cette valeur du couple de rotation mécanique ($M_m$) est égalisée avec une réduction au couple d'accélération calculé à partir du moment d'inertie ($J_p$) et de la modification du nombre de tours ($d_{wm}/d_t$).

2. Procédé selon la revendication 1, caractérisé en ce que les parties de puissance dissipée ($V_{WR}$) du mutateur (2), en particulier les pertes à l'état passant ($V_{WR-D}$), de connexion ($V_{WR-S}$) et de commutation ($V_{WR-K}$) sont calculées à partir de l'intensité ($I_d$) mesurée dans le circuit intermédiaire, de la fréquence fondamentale du stator ($f_s$) pouvant être obtenue à partir de l'électronique de commande et de réglage (4) du mutateur (1, 2) et des caractéristiques du mutateur, en particulier des caractéristiques statiques et dynamiques de thyristors et de diodes et des éléments de connexion de ceux-ci.

3. Procédé selon la revendication 1 ou 2, caractérisé en ce que les parties de puissance dissipée ($V_{ASM}$) de la machine (3) soustraites de la puissance active ($P_{ZK}$) dans le circuit intermédiaire, qui se composent des pertes dans le cuivre du stator ($V_{Cu1}$), dans le fer ($V_{Fe}$), de supplément ($V_{Zus}$), de friction ($V_{Rb}$) et fondamentale du rotor, sont calculées à partir de l'intensité ($I_d$) du circuit intermédiaire et des résistances équivalentes calculées à partir des paramètres de la machine, les résistances équivalentes dépendant de la fréquence fondamentale du stator ($f_s$) et de la température du stator ($T_s$) mesurée, par exemple, avec une résistance thermométrique.

4. Procédé selon l'une ou l'ensemble des revendications 1 à 3, caractérisé en ce que pour le calibrage la machine asynchrone (3) est couplée avec un entraînement dont le couple de rotation est réglable, qui offre un couple de référence ($M_{m,ref}$) mesuré de manière mécanique, en ce que la plage de fréquences de la machine asynchrone (3) est parcourue à trois valeurs de couple de charge différentes, de préférence à vide, à 2/3 de la puissance et à pleine puissance, et en ce que la différence appropriée des puissances de champ rotatif ($\Delta\widetilde{P}_D$) modifiées correspondantes est calculée à partir de la différence entre le couple de référence ($M_{m,ref}$) appliqué et le couple de rotation ($M_m$) calculé et permet de déterminer une fonction de correction ($V_{add}(f_s,I_d)$) dépendant de la fréquence et de l'intensité.

5. Dispositif pour la réalisation du procédé selon l'une ou l'ensemble des revendications 1 à 4, caractérisé en ce qu'un micro-ordinateur (8) est relié avec une unité d'entrée-sortie (7) qui reçoit dans le cas d'utilisation les valeurs d'intensité ($I_d$) et de tension ($U_d$) dans le circuit intermédiaire du mutateur (1, 2), en ce que le micro-ordinateur (8) peut calculer dans un programme déposé dans son unité de mémoire la puissance active ($P_{ZK}$) dans le circuit intermédiaire et la déposer dans un emplacement en mémoire libre dans l'unité de mémoire et en ce qu'un autre programme déposé dans le micro-ordinateur (8) peut calculer la puissance de champ rotatif ($\widetilde{P}_D$) modifiée et la diviser par la fréquence de circuit fondamentale du stator ($W_s$) obtenue à partir de l'électronique de commande et de réglage (4) du mutateur (1, 2) et amenée à l'unité d'entrée-sortie (7).

6. Dispositif selon la revendication 5, caractérisé en ce que le micro-ordinateur (8) peut calculer avec un programme les parties de puissance dissipée ($V_{WR}$) du mutateur (2), avec l'intensité ($I_d$) mesurée dans le circuit intermédiaire, la fréquence fondamentale du stator ($f_s$) et les caractéristiques du mutateur déposées dans les emplacements de mémoire libres de l'unité de mémoire du micro-ordinateur (8).

7. Dispositif selon l'une ou l'ensemble des revendications 5 et 6, caractérisé en ce que le micro-ordinateur (8) peut calculer avec un programme les parties de puissance dissipée ($V_{ASM}$) à partir des résistances équivalentes dépendant de la fréquence et de la température déposées dans des emplacements de mémoire libre dans l'unité de mémoire, qui sont calculées dans le micro-ordinateur (8) à partir des paramètres de machine stockés dans des mémoires de constantes par un autre programme, de l'intensité ($I_d$) du circuit intermédiaire, de la fréquence fondamentale ($f_s$) du stator et de la température du stator ($T_s$).

Fig.1

EP 0 500 706 B1

$P_{ZK}$ $P_1$ $\tilde{P}_D$ $P_m$

$V_{WR}$ $V_{Fe}+V_{Cu1}+V_{Zus}$ $V_{Rb}$ $V_{Cu2}-V_{Cu2,1}$ $V_{Cu2,1}$

Fig. 2

a) [ ]

b) $$f_s,\ \omega_m,\ U_d,\ I_d,\ T_s$$

c) $$P_{ZK} = \bar{U}_d \cdot \bar{I}_d$$

d) $$V_{WR} = V_{WR,D} + V_{WR,S} + V_{WR,K}$$

e) $$V_{ASM} = V_{Rb} + V_{Fe} + V_{zus} + V_{zul} + V_{Cu1} + (V_{Cu2} - V_{Cu2,1})$$

f) $$\tilde{P}_D = P_{ZK} - V_{WR} - V_{ASM} - V_{add}$$

g) $$M_m = \frac{P_D}{\omega_s}\, p - J_p \frac{\Delta\omega_m}{T}$$

Fig. 3

a) $\quad M_m \approx 0; \quad f_s = f_{s,i}, \quad i = i..n$

$\qquad M_m - M_{m,ref} \longrightarrow \Delta \widetilde{P}_{D0,i}$

$\quad M_m \approx 2/3M_N \quad f_s = f_{s,i}, \quad i = i..n$

$\qquad M_m - M_{m,ref} \longrightarrow \Delta \widetilde{P}_{D1,i}$

$\quad M_m \approx M_N; \quad f_s = f_{s,i}, \quad i = i..n$

$\qquad M_m - M_{m,ref} \longrightarrow \Delta \widetilde{P}_{D2,i}$

b) $\quad i = i..n$

$\Delta \widetilde{P}_{D0,i}, \quad \Delta \widetilde{P}_{D1,i}, \quad \Delta \widetilde{P}_{D2,i}$

$\longrightarrow V_{add0}(f_{s,i}), \quad V_{add1}(f_{s,i}), \quad V_{add2}(f_{s,i})$

c) $\quad j = i..m$

$V_{add0}(f_s) = a_{0,j} + b_{0,j} \cdot f_s$

$V_{add1}(f_s) = a_{1,j} + b_{1,j} \cdot f_s$

$V_{add2}(f_s) = a_{2,j} + b_{2,j} \cdot f_s$

d) $\quad \left.\begin{array}{l}(a_0, \; b_0)_j \\ (a_1, \; b_1)_j \\ (a_2, \; b_2)_j\end{array}\right\} \quad j = i..m$

Fig. 4